# EUROPEAN PATENT SPECIFICATION

(11) **EP 0 753 856 B1**
(45) Date of publication and mention of the grant of the patent: **05.09.2001**
(21) Application number: 96110335.5
(22) Date of filing: 27.06.1996
(51) Int. Cl.: G11C 7/00

(54) **Semiconductor memory device having circuit array structure for fast operation**
Halbleiterspeicheranordnung mit einer Schaltungsanordnungstruktur für hohe Geschwindigkeit
Dispositif de mémoire à semi-conducteurs ayant une structure de circuit de réseau pour fonctionnement rapide

(30) Priority: 29.06.1995 KR 1829195
(43) Date of publication of application: 15.01.1997
(73) Proprietor: SAMSUNG ELECTRONICS CO., LTD., Suwon-city, Kyungki-do 441-373 (KR)
(72) Inventor: Yoo, Jei-Hwan, Suwon-city, Kyungki-do (KR); Lee, Jung-Hwa, Paldal-gu, Suwon-city, Kyungki-do (KR)
(74) Representative: Eisenführ, Speiser & Partner

(56) References cited:
- EP-A- 0 544 247
- US-A- 5 109 265
- US-A- 5 369 619

## Description

The present invention relates to a semiconductor memory device, and more particularly, to a memory circuit array structure which enables to minimize damage of speed due to skew between data bit in operation of a high-speed memory device and reduce a size of memory circuit array.

Generally, as memory capacity increases in a semiconductor memory device, in particular in a dynamic RAM, size is considerably enlarged. Owing to the development of process technology, the width of a bus line narrows notably increasing loading to memory circuit technology. Nevertheless, a need for faster, low consumption of power and byte wide products are growing in the field of future memory devices. To respond to such trends, various memory architectures are under development, along with diverse technology in relation to feature enhancement.

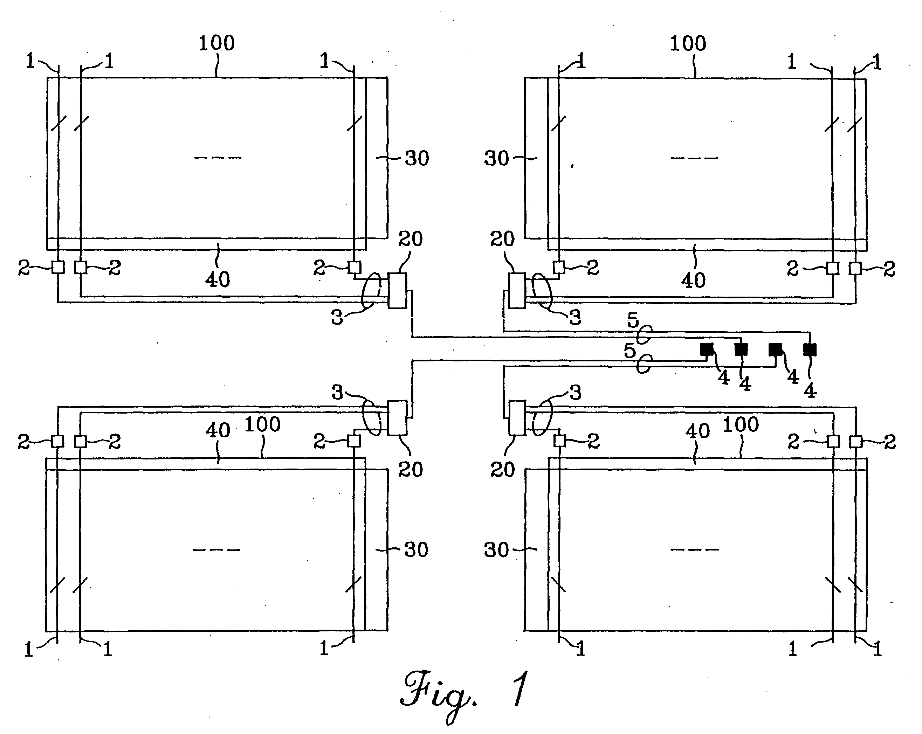

Fig. 1 shows a data route and circuit array according to conventional technology. Referring to Fig. 1, there is provided a memory cell array block 100; a column decoder 40 disposed between two memory cell arrays; a row decoder 30 arranged toward a chip center portion of each memory cell array block; a data input/output buffer 4 disposed to the right side of the center of the horizontal direction of the memory cell array block 100; and a data sense amplifier and data input driver 2 by connecting each of or a plurality of data input/output lines 1 with a switching means 20. A output data line packet 3 is wired at the center of the chip and connected to the switching means 20. Thus, a piece or a few pieces of data are transferred to a data bus 5 which is connected with the data input/output buffer 4.

In such a memory structure, when the cells at both side ends of the memory cell array block 100 are accessed, the speed difference between two pieces of data appears greater in accordance with the memory chip capacity. Also, since the data sense amplifiers 2 are arranged to each or a plurality of the data input/output lines 1 structured to the memory cell array block 100, the memory circuit array area increases considerably. Furthermore, in a case of concurrently outputting more pieces of data in the memory cell array to implement high bandwidth, larger circuit array area and power consumption are entailed.

Accordingly, it is an object of the present invention to provide a memory circuit array structure which enables to minimize loss of speed due to skew between data bits in the operation of a high-speed memory device.

It is another object of the present invention to provide a memory circuit array structure which requires lower power consumption during circuit operation and less circuit array area compared with the conventional technology in a semiconductor device implementing high bandwidth.

Thus, to achieve the above objects, there is provided a semiconductor memory device, as defined in claim 1 or claim 2.

Preferable embodiments of the invention are defined in the dependent claims.
- FIG. 1: is a view illustrating data route and circuit array according to the conventional technology; and
- FIG. 2: is a view illustrating data route and circuit array according to the present invention.

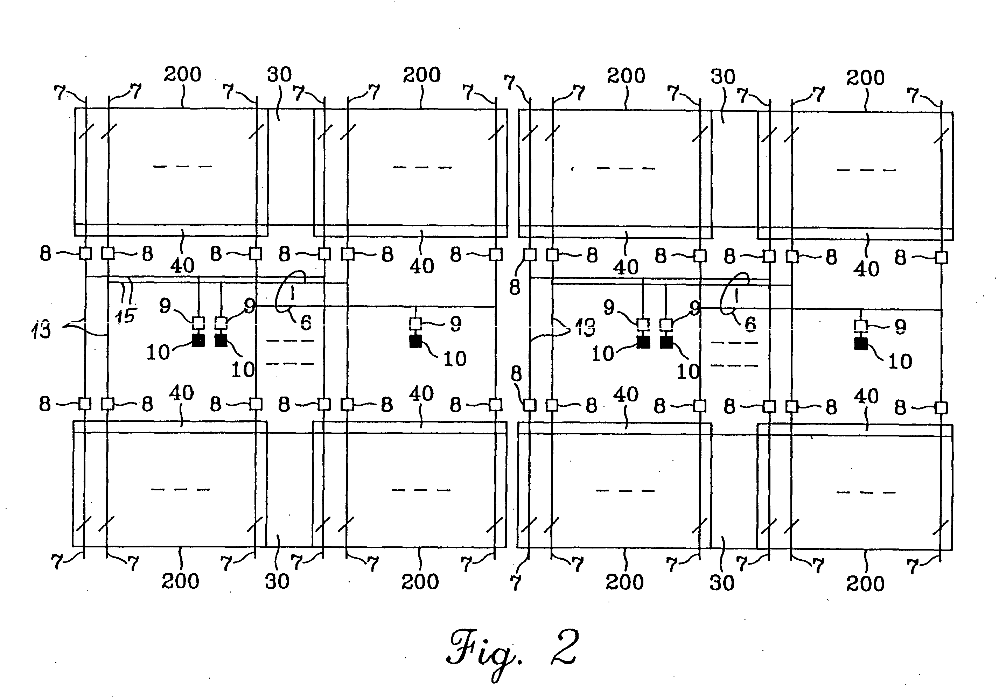

Referring to Fig. 2, a plurality of memory cell array blocks 200 is provided. A row decoder 30 is provided between two horizontally adjacent memory cell array blocks to control word lines, and column decoders 40 are arranged at the central portion of a chip between the memory cell arrays 200 to thereby curtail the data routes of vertically disposed input/output lines 7 at its maximum. At least four structures each constituted by such two memory cell array blocks 200 are arranged around the chip central portion. With reference to the center of the chip, each of the memory cell array block structures 200 at the left and right sides thereof has individual data input/output pad, which is characteristic in the present invention.

Also, compared with the conventional technology where a data sense and drive amplifier is connected to each input/output line, there is provided as an input/output means 8 a switching means or sense amplifier enabled during reading and an input/output driver enabled during writing in the present invention. Input/output means 8 at the same position in each memory cell array block 200 are connected to first data lines 13, and second data lines 15 in a horizontal direction of the chip center portion constitute a second data line packet 6 are shifted at a constant interval. Thus, speed difference between separate data lines 13 can be effectively minimized.

Further, the difference of data access time between data input/output pads 10 is sharply reduced by arranging data buffer means 9 comprising a data sense amplifier and data input/output buffer amplifier being connected to input/output pads 10 at each central portion of the second data lines 15. By constituting the memory cell array block 200 as mentioned above, the data of a plurality of the memory cells which is selected by a row address and a column address is loaded or sensed via the input/output lines 7. Then, only one input/output means 8 is enabled by address to thereby connect the input/output line 7 and the vertical first data line 13 so that the data can be transmitted to the data buffer means 9. Accordingly, since one data buffer means 9 shares four or more input/output lines 7 disposed at an individual memory cell array block 200 and selectively connected according to address input information, the number of the data sense amplifiers of the data buffer means 9 in the entire memory chip is reduced to ¼ relative to conventional technology.

Since it is the trend in a future semiconductor memory to implement high bandwidth, in such a memory device as a synchronous DRAM where a large amount of data can be read and written concurrently the number of input/output lines 7 arranged in a memory cell array 200 increases considerably. As a result, input/output line control circuits such as input/output sense amplifiers or drivers are required accordingly as the input/output lines 7 increases in number. Therefore, in a semiconductor memory device covering the high bandwidth, the present invention has an effect in that a relatively small layout area and low power consumption during circuit operation can be achieved.

Whereas the invention was described in connection with at least four memory cell array blocks 200, it is also advantageous if only at least two memory cell array blocks 200 are used vertically arranged to each other, with column decoders 40 arranged between the memory cell array blocks 200. Moreover, it is herewith noted that when the memory cell array blocks 200 are defined to be arranged horizontally or vertically in relation to each other, with this position the arrangement in the block diagram of Fig. 2 is meant.

## Claims

1. A semiconductor memory device including at least four memory cell array blocks (200) constituted by arraying memory cells and row and column decoders (30, 40) for respectively controlling word lines and bit lines being disposed inside each of said memory cell array blocks (200), said semiconductor memory device comprising:
input/output lines (7) for each said memory cell array block (200) for inputting/outputting data;
input/output means (8), connected to said input/output lines (7), for controlling and driving input/output of the data;
first data lines (13) for transmitting the data, being disposed between said input/output means (8) of one memory cell array block (200) and said input/output means (8) of another memory cell array block (200) arranged in a vertical direction with respect to said one memory cell array block (200);
second data lines (15) for transmitting the data by connecting at least two first data lines (13) disposed in a horizontal direction;
data buffer means (9), connected to said second data lines (15), for inputting and outputting the data; and
data input/output pads (10), connected to said data buffer means (9) and arranged in the horizontal direction of a central portion of the semiconductor memory device for inputting and outputting data from/to an external lead frame.

2. A semiconductor memory device including at least two memory cell array blocks (200) constituted by arraying memory cells and vertically arranged with reference to a pad area there between and a column decoder (40) for controlling bit lines being disposed inside each of said memory cell array blocks (200), said semiconductor memory device comprising:
input/output lines (7) for each said memory cell array block (200) for inputting/outputting data;
input/output means (8), connected to said input/output lines (7), for controlling and driving input/output of the data;
first data lines (13) for transmitting the data, being disposed between said input/output means (8) of one memory cell array block (200) and said input/output means (8) of another memory cell array block (200) arranged in a vertical direction with respect to said one memory cell array block (200); and
second data lines (15) disposed in a horizontal direction and connected to said first data lines (13); data buffer means (9), connected to said second data lines (15), for inputting and outputting the data; and
data input/output pads (10), connected to said data buffer means (9) and arranged in the horizontal direction in said pad area, for inputting and outputting data from/to an external lead frame.

3. A semiconductor memory device as claimed in claim 1 or 2, wherein said input/output means (8) comprises an input/output switch and an input/output driver.

4. A semiconductor memory device as claimed in claim 1 or 2, wherein said input/output means (8) comprises a write driver and a data sense amplifier.

5. A semiconductor memory device as claimed in claim 1 or 2, wherein said data buffer means (9) comprises a dates input/amplifier and a data sense amplifier.

6. A semiconductor memory device as claimed in claim 2, comprising at least four or a multiple of four of said memory cell array blocks (200).

7. A semiconductor memory device as claimed in claim 1 or 2, wherein said input/output pads are respectively disposed at the central portion of the second data lines.

## Patentansprüche

1. Halbleiterspeichervorrichtung, enthaltend mindestens vier Speicherzellen-Reihenblöcke (200), die durch Aneinanderreihen von Speicherzellen sowie Reihen- und Spaltendecoder (30, 40) zum Steuern von Wortzeilen bzw. Bitzeilen, die innerhalb jedes der Speicherzellen-Reihenblöcke (200) angeordnet sind, aufgebaut sind, wobei die Halbleiterspeichervorrichtung enthält:
Eingabe-/Ausgabeleitungen (7) für jeden Speicherzellenreihenblock (200) zum Eingeben/Ausgeben von Daten,
Eingabe-/Ausgabemittel (8), die mit den Eingabe-/Ausgabeleitungen (7) verbunden sind, um die Eingabe/Ausgabe der Daten zu kontrollieren und zu steuern,
erste Datenleitungen (13) zum Übertragen der Daten, die zwischen den Eingabe-/Ausgabemitteln (8) eines Speicherzellen-Reihenblocks (200) und den Eingabe-/Ausgabemitteln (8) eines weiteren Speicherzellen-Reihenblocks (200) angeordnet sind, welcher in einer vertikalen Richtung, bezogen auf diesen einen Speicherzellen-Reihenblock (200), vorgesehen ist,
zweite Datenleitungen (15) zum Übertragen der Daten durch Verbinden von zumindest zwei ersten Datenleitungen (13), die in einer horizontalen Richtung angeordnet sind,
Datenbuffermittel (9), die mit den zweiten Datenleitungen (15) verbunden sind und die zum Eingeben und Ausgeben der Daten vorgesehen sind, und
Dateneingabe-/Datenausgabepads (10), die mit den Datenbuffermitteln (9) verbunden sind, und die in horizontaler Richtung eines Mittenabschnitts der Halbleiterspeichervorrichtung zum Eingeben und
Ausgeben von Daten von und zu einem außerhalb angeordneten Leitungsframe angeordnet sind.

2. Halbleiterspeichervorrichtung, die wenigstens zwei Speicherzellen-Reihenblöcke (200) aufweist, die durch Aneinanderreihen von Speicherzellen aufgebaut sind und die bezogen auf einen dazwischenliegenden Padbereich vertikal angeordnet sind, und einen Spaltendecoder (40) zum Steuern der Bitzeilen, der innerhalb jedes Speicherzellen-Reihenblocks (200) angeordnet ist, wobei die Halbleiterspeichervorrichtung enthält:
Eingabe-/Ausgabeleitungen (7) für jeden Speicherzellen-Reihenblock (200) zum Eingeben/Ausgeben von Daten,
Eingabe-/Ausgabemittel (8), die mit den Eingabe-/Ausgabeleitungen (7) verbunden sind und die zur Kontrolle und Steuerung der Eingabe/Ausgabe der Daten vorgesehen sind,
erste Datenleitungen (13) zum Übertragen der Daten, wobei die ersten Datenleitungen zwischen den Eingabe-/Ausgabemitteln (8) eines Speicherzellen-Reihenblocks (200) und den Eingabe-/Ausgabemittein (8) eines weiteren Speicherzellen-Reihenblocks (200), welcher in einer vertikalen Richtung bezogen auf diesen einen Speicherzellen-Reihenblock (200) angeordnet ist, vorgesehen sind, und
zweite Datenleitungen (15), die in einer horizontalen Richtung angeordnet sind und die mit den ersten Datenleitungen (13) verbunden sind, Datenbuffermittel (9), die mit den zweiten Datenleitungen (15) zum Eingeben und Ausgeben der Daten verbunden sind, und
Dateneingabe-/Datenausgabepads (10), die mit den Datenbuffermitteln (9) verbunden sind, und die in horizontaler Richtung in diesem Padbereich zum Eingeben und Ausgeben von Daten aus einem bzw. zu einem außenliegenden Leitungsframe angeordnet sind.

3. Halbleiterspeichervorrichtung nach Anspruch 1 oder 2,
bei der das Eingab-/Ausgabemittel (8) einen Eingabe/Ausgabeschalter sowie eine Eingabe-/Ausgabeansteuereinrichtung enthält.

4. Halbleiterspeichervorrichtung nach Anspruch 1 oder 2,
bei der das Eingabe-/Ausgabemittel (8) eine Schreibansteuereinrichtung sowie einen Datenerfassungsverstärker enthält.

5. Halbleiterspeichervorrichtung nach Anspruch 1 oder 2,
bei der die Datenbuffermittel (9) einen Dateneingabeverstärker sowie einen Datenerfassungsverstärker enthalten.

6. Halbleiterspeichervorrichtung nach Anspruch 2,
enthaltend mindestens vier Speicherzellen-Reihenblöcke (200) oder ein Mehrfaches der vier Speicherzellen-Reihenblöcke (200).

7. Halbleiterspeichervorrichtung nach Anspruch 1 oder 2,
bei der die Eingabe-/Ausgabepads jeweils an dem Mittenabschnitt der zweiten Datenleitungen vorgesehen sind.

## Revendications

1. Dispositif de mémoire à semi-conducteurs comprenant au moins quatre blocs de matrices de cellules de mémoire (200) constitués par matriçage de cellules de mémoire, et des décodeurs de colonnes et de lignes (30, 40) pour contrôler respectivement des lignes de mots et des lignes binaires qui sont disposées à l'intérieur de chacun desdits blocs de matrices de cellules de mémoire (200), ledit dispositif de mémoire à semi-conducteurs comprenant :
des lignes d'entrée/sortie (7) pour chacun desdits blocs de matrices de cellules de mémoire (200) pour entrer/sortir des données ;
des moyens d'entrée/sortie (8), reliés aux dites lignes d'entrée/sortie (7), pour contrôler et gérer l'entrée/sortie des données ;
de premières lignes de données (13) pour transmettre les données, étant disposées entre lesdits moyens d'entrée/sortie (8) d'un bloc de matrices de cellules de mémoire (200) et lesdits moyens d'entrée/sortie d'un autre bloc de matrices de cellules de mémoire (200) disposé selon une direction verticale par rapport audit un bloc de matrices de cellules de mémoire (200) ;
de secondes lignes de données (15) pour transmettre les données en reliant au moins deux premières lignes de données (13) disposées horizontalement ;
de moyens tampons de données (9), reliés aux dites secondes lignes de données (15), pour entrer et sortir les données ; et
de touches d'entrée/sortie de données (10), reliées aux dits moyens tampons de données (9) et disposées selon la direction horizontale d'une partie centrale du dispositif de mémoire à semi-conducteurs pour entrer et sortir des données à partir ou vers un cadre de montage externe.

2. Dispositif de mémoire à semi-conducteurs comprenant au moins deux blocs de matrices de cellules de mémoire (200) constitués par matriçage de cellules de mémoire de tableaux et disposés verticalement de part et d'autre d'une zone de contact, et un décodeur de colonnes (40) pour contrôler les lignes binaires disposées à l'intérieur de chaque bloc de matrices de cellules de mémoire (200), ledit dispositif de mémoire à semi-conducteur comprenant :
des lignes d'entrée/sortie (7) pour chaque bloc de matrices de cellules de mémoire (200) pour entrer/sortir des données ;
des moyens d'entrée/sortie (8), reliés aux dites lignes d'entrée/sortie(7), pour contrôler et gérer l'entrée/sortie des données ;
de premières lignes de données (13) pour transmettre les données, étant disposées entre lesdits moyens d'entrée/sortie (8) d'un bloc de matrices de cellules de mémoire (200) et lesdits moyens d'entrée/sortie (8) d'un autre bloc de matrices de cellules de mémoire (200) selon une direction verticale par rapport au dit un bloc de matrices de cellules de mémoire (200) ; et
de secondes lignes de données (15) disposées horizontalement et reliées aux dites premières lignes (13) de données ; des moyens tampons de données (9), reliés aux dites secondes lignes de données (15), pour entrer et sortir les données ; et
des touches d'entrée/sortie de données (10); reliées aux dits moyens tampons de données (9) et disposées horizontalement dans ladite zone de touches, pour entrer/sortir des données à partir de/vers un cadre de montage externe.

3. Dispositif de mémoire à semi-conducteurs selon la revendication 1 ou 2, dans lequel lesdits moyens d'entrée et de sortie (8) comprennent un commutateur d'entrée/sortie et un gestionnaire d'entrée/sortie.

4. Dispositif de mémoire à semi-conducteurs selon la revendication 1 ou 2, dans lequel lesdits moyens d'entrée/sortie (8) comprennent un gestionnaire d'écriture et un amplificateur de détection de données.

5. Dispositif de mémoire à semi-conducteurs selon la revendication 1 ou 2, dans lequel lesdits moyens tampons de données (9) comprennent un amplificateur d'entrée de données et un amplificateur de détection de données.

6. Dispositif de mémoire à semi-conducteurs selon la revendication 2, comprenant au moins quatre ou un multiple de quatre desdits bloc de matrices de cellules de mémoire (200).

7. Dispositif de mémoire à semi-conducteur selon la revendication 1 ou 2, dans lequel lesdites touches d'entrée/sortie sont respectivement disposées dans la partie centrale des secondes lignes de données.
